# EUROPEAN PATENT SPECIFICATION

(11) **EP 3 408 902 B1**
(45) Date of publication and mention of the grant of the patent: **19.01.2022**
(21) Application number: 16823466.4
(22) Date of filing: 20.12.2016
(51) Int. Cl.: H01S 5/02, G02B 6/12, H01S 5/026, H01S 5/10, H01S 5/14, H01S 5/34, H01S 3/067

(54) **MULTI-FREQUENCY HYBRID TUNABLE LASER**
ABSTIMMBARER HYBRIDER MULTIFREQUENZLASER
LASER HYBRIDE ACCORDABLE MULTIFRÉQUENCE

(30) Priority: 26.01.2016 US 201662287158 P
(43) Date of publication of application: 05.12.2018
(73) Proprietor: Alcatel-Lucent USA Inc., Murray Hill, NJ 07974-0636 (US)
(72) Inventor: EGGLESTON, Michael, Murray Hill NJ 07974-0636 (US); DE VALICOURT, Guilhem, Holmdel NJ 07733-1661 (US)
(74) Representative: MERH-IP Matias Erny Reichl Hoffmann Patentanwälte PartG mbB
(86) International application number: PCT/US2016/067722
(87) International publication number: WO 2017/131898

(56) References cited:
- GB-A- 2 522 252
- US-A1- 2004 228 564
- US-A1- 2010 296 812
- US-A1- 2012 195 332
- US-A1- 2014 133 511
- US-A1- 2015 180 201

## Description

### TECHNICAL FIELD

The present disclosure is directed, in general, to lasers and devices using such lasers.

### BACKGROUND

This section introduces aspects that may help facilitate a better understanding of the present disclosure. Accordingly, the statements of this section are to be read in this light and are not to be understood as admissions about what is in the prior art or what is not in the prior art.

Cost reduction in wavelength division multiplexing (WDM) networks is typically one of the major issues to be taken into account. In order to provide lasers capable of producing a multiplicity of wavelengths one known approach is optically coupling a tunable laser to a respective modulator for each of the wavelengths to be transmitted. This would imply the use of as many lasers as there are wavelengths to be transmitted. A more cost-effective approach is the use of comb sources and multi-frequency lasers.

As an example of the prior art, the Patent Application US 2014/133511 A1 discloses a multi-wavelength semiconductor amplifier associated with a silicon photonic integrated circuit providing multiple parallel optical filtering.

### SUMMARY

The present disclosure relates to a multi-cavity hybrid laser comprising an inhomogeneously broadened gain material and a silicon photonic platform. Each cavity may be tuned continuously as desired and the laser can simultaneously lase at different optical frequencies.

Some embodiments feature an apparatus comprising:
- an optical amplifier having an inhomogeneously broadened gain material configured to generate a plurality of ensemble gains; and
- a silicon photonic integrated circuit including a first optical filter and a second optical filter;
wherein a first laser cavity includes the optical amplifier and the first optical filter optically coupled to each other and at least two mirrors, and the first optical filter is tunable to a respective first ensemble gain generated by the optical amplifier;
wherein a second laser cavity includes the optical amplifier and the second optical filter optically coupled to each other and at least two mirrors, and the second optical filter is tunable to a respective second ensemble gain generated by the optical amplifier; and
wherein the second ensemble gain is different from the first ensemble gain.

According to some specific embodiments the optical amplifier is provided on a first substrate and the silicon photonic integrated circuit is provided o a second substrate, the first substrate and the second substrate together forming a hybrid structure.

According to some specific embodiments the optical amplifier is provided using erbium doped fiber and the silicon photonic integrated circuit is provided on a substrate wherein the erbium doped fiber and the substrate comprising the silicon photonic integrated circuit form together a hybrid structure.

According to some specific embodiments the first optical filter and the second optical filter support different optical frequency modes and the optical amplifier is configured to generate multiple ensemble gains corresponding to said different optical frequency modes.

According to some specific embodiments the first laser cavity comprises a first mirror with a first reflectivity and a second mirror with a second reflectivity, such that the first reflectivity is lower than the second reflectivity and the second laser cavity comprises the first mirror and the second mirror.

According to some specific embodiments the first laser cavity comprises a first mirror with a first reflectivity and a second mirror with a second reflectivity, such that the first reflectivity is lower than the second reflectivity and the second laser cavity comprises the first mirror first mirror and a third mirror with a third reflectivity, such that the first reflectivity is lower than the third reflectivity.

According to some specific embodiments the first optical filter comprises a first ring resonator pair which includes a first ring resonator having a first free spectral range and a second ring resonator having a second free spectral range, wherein the first free spectral range is different from the second free spectral range, such that the first ring resonator pair is configured to produce a Vernier effect on an optical signal.

According to some specific embodiments the second optical filter comprises a second ring resonator pair which includes a third ring resonator having a third free spectral range and a fourth ring resonator having a fourth free spectral range, wherein the third free spectral range is different from the fourth free spectral range, such that the second ring resonator pair is configured to produce a Vernier effect on an optical signal.

According to some specific embodiments the apparatus comprises a phase shifter.

According to some specific embodiments the first laser cavity comprises a first variable optical attenuator configured to attenuate the first ensemble gain in a switched ON condition and allow a passage of said first ensemble gain in a switched OFF condition.

According to some specific embodiments the apparatus comprises a plurality of laser cavities, each comprising a respective variable optical attenuator configured to attenuate an optical signal amplified by a respective ensemble gain in said cavity in a switched ON condition and allow a passage of said respective ensemble gain in a switched OFF condition.

According to some specific embodiments the silicon photonic integrated circuit and the optical amplifier are butt-coupled to each other.

According to some specific embodiments the inhomogenously broadened material of the optical amplifier is within a semiconductor optical amplifier comprising a quantum dot gain medium.

According to some specific embodiments the inhomogenously broadened material of the optical amplifier is within an Erbium Doped Fiber Amplifier.

According to some specific embodiments the second mirror is a Sagnac loop mirror, ring-based mirror, Bragg grating or a Bragg grating fiber.

According to some specific embodiments the first mirror is a partially reflective Bragg grating fiber, a partially reflective Bragg grating, a partially reflective cleaved fiber or a partially reflective Sagnac loop mirror.

Some embodiments feature laser source comprising:
- an optical amplifier having an inhomogeneously broadened gain material configured to generate a plurality of ensemble gains; and
- a silicon photonic integrated circuit including a first optical filter and a second optical filter;
wherein a first laser cavity includes the optical amplifier and the first optical filter optically coupled to each other and at least two mirrors, and the first optical filter is tunable to a respective first ensemble gain generated by the optical amplifier;
wherein a second laser cavity includes the optical amplifier and the second optical filter optically coupled to each other and at least two mirrors, and the second optical filter is tunable to a respective second ensemble gain generated by the optical amplifier; and
wherein the second ensemble gain is different from the first ensemble gain.

Some embodiments feature a transmitter comprising:
- a modulator;
- an optical amplifier having an inhomogeneously broadened gain material configured to generate a plurality of ensemble gains; and
- a silicon photonic integrated circuit including a first optical filter and a second optical filter;
wherein a first laser cavity includes the optical amplifier and the first optical filter optically coupled to each other and at least two mirrors, and the first optical filter is tunable to a respective first ensemble gain generated by the optical amplifier;
wherein a second laser cavity includes the optical amplifier and the second optical filter optically coupled to each other and at least two mirrors, and the second optical filter is tunable to a respective second ensemble gain generated by the optical amplifier; and
wherein the second ensemble gain is different from the first ensemble gain.

### BRIEF DESCRIPTION OF THE DRAWINGS

The embodiments of the disclosure are best understood from the following detailed description, when read with the accompanying figures. Various features may not be drawn to scale and may be arbitrarily increased or reduced in size for clarity of discussion. Reference is now made to the following descriptions taken in conjunction with the accompanying drawings, in which:
FIG. 1 is a schematic representation of a tunable laser according to known solutions.
FIG. 2 is a schematic representation of gain spectra produced by an inhomogenously broadened material.
FIG. 3 is a schematic representation of an example of a multi-wavelength tunable apparatus according to some embodiments.
FIG. 4 is a representation of an example of gain functions and wavelengths produced by an apparatus according to some embodiments.
FIG. 5 shows schematic representations of various examples of laser cavity configurations according to some embodiments.
FIG. 6 is a schematic representation of an example of an apparatus according to some embodiments.

### DETAILED DESCRIPTION OF ILLUSTRATIVE EMBODIMENTS

As mentioned above the use of comb sources (i.e. an optical source capable of generating a spectrum of a plurality of separate wavelengths) is regarded as a more preferable approach in multi-wavelength transmission as it does not require the use of one laser per wavelength, but rather only one comb source may be used which can be optically coupled to several modulators. This approach is particularly interesting for silicon photonics where all modulators can be fabricated in the same platform, although the laser would typically need to be provided in III-V material which is expensive.

Before describing further details of the proposed hybrid tunable laser, some examples of the existing solution for generating a plurality of wavelengths on a single chip are provided in the following.

One known solution includes the use of arrayed waveguide gratings (AWG) in the laser structure. A laser manufactured based on AWG (herein also referred to as AWG-laser) may be used as a fast wavelength tunable laser by switching ON and OFF each of the channels propagating through the AWG. The AWG-laser comprises an AWG filter incorporated in the laser cavity which is made using an InP platform.

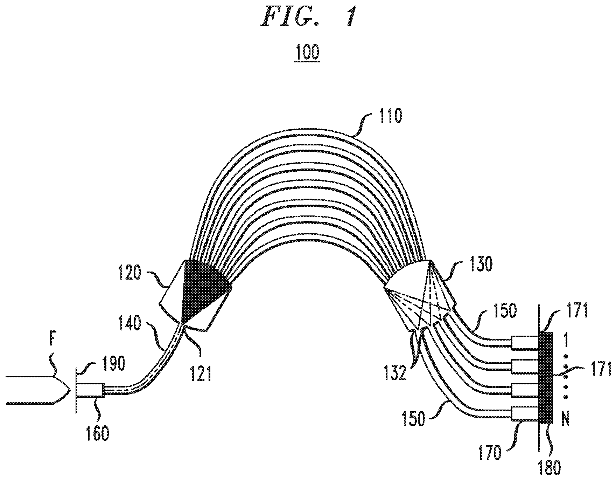

FIG. 1 represents a schematic view of an AWG-laser 100 according to such known approach. The AWG laser 100 comprises an AWG element which includes an array of waveguides 110, a first free space region 120 coupled to a respective end of each one of the waveguides of the array 110 and a second free space region 130 coupled to another respective end of each one of the waveguides of the array 110. An input waveguide 140 is optically coupled to an input port 121 of the first free space region 120 and a plurality of output waveguides 150 are each coupled to respective output ports 132 of the second free space region 130. This configuration of the AWG is well-known in the related art.

The AWG-laser 100 further includes a first semiconductor optical amplifier (SOA) 160 optically coupled to the input waveguide 140 and an array of second semiconductor optical amplifiers (SOAs), collectively shown by reference numeral 170, such that each SOA from the array of SOAs 170 is optically coupled to an end of a respective one of the output waveguides from the plurality of the output waveguides 150.

The AWG-laser 100 further includes an array of mirrors, collectively shown by reference numeral 180. Each mirror from the array of mirrors 180 is coupled, at a respective facet thereof, to a respective output 171 of an SOA from the array of SOAs170. The AWG-laser 100 further includes a partially reflective mirror 190.

In operation, an optical signal propagates in forward and backward directions and in each direction of propagation it is amplified. The combined arrangement of the AWG, the first SOA, the array of SOAs, the partially reflective mirror and array of mirrors, as described above constitutes a laser cavity which can amplify light at each back and forth propagation until the optical signal reaches the lasing threshold and the AWG-laser 100 starts to lase. The output power of the laser is coupled to an optical fiber F.

In order to provide tunability in the AWG-laser 100, each SOA from the array of SOAs 170 is turned ON in order to emit one wavelength and is turned OFF in order to inhibit the emission of the corresponding wavelength.

The AWG-laser of FIG. 1 is therefore capable of providing a multi-frequency laser as it is capable of emitting several wavelengths at the same time. However an integration of this laser structure in an InP platform should typically exhibit a large footprint (e.g. 18 cm × 9 mm). Such large size introduces certain drawbacks, including but not limited to high cost (as InP material is typically more expensive than silicon material) and the modal selectivity as long Fabry-Perot cavities typically induce closer longitudinal modes.

Silicon photonics technology is viewed as a promising candidate for making intra-cavity filters (AWG in the example above) as it allows for high-density integration and production with the benefit of large-scale manufacturing. This technology in a complementary metal-oxide-semiconductor (CMOS) platform may enable the fabrication of low cost and compact circuits that integrate photonic and microelectronic elements. However, in the known approaches, light emission and amplification is typically not available. As a consequence, some of the known approaches have focused on heterogeneous integrations of III-V semiconductors on silicon, which is often a complex process. Several approaches for providing hybrid III-V/Si lasers have been proposed. Some examples are: 1) using an external III-V chip coupled via an optical fiber, free-space or butt-coupling; 2) bonding of III-V dies/wafers onto a processed Si wafer; 3) using electrically pumped highly strained and heavily doped Ge materials; and 4) the use of III-V on Si hetero-epitaxy. The first approach has already been implemented in commercial products, but suffers from high cost, as each gain chip typically needs to be aligned with a silicon waveguide or an optical fiber. However, up to now this approach has proved among the in terms of best performance of tunable lasers. The second approach using the bonding of III-V dies/wafers seems promising however it typically involves a complex process and foundries do not appear to be prepared for providing such service for now. The third and fourth approaches are being intensively developed but practical applications seem to be far from immediate achievement.

Such hybrid silicon devices have the optical properties of the III-V material, such as gain (emission or amplification), high-speed modulation, and photodetection, while still being located on a silicon-on-insulator (SOI) circuit.

Hybrid III-V/Si multi-wavelength lasers based on wafer bonding techniques, for example the AWG-based or ring-based lasers, are already known. However in the know devices, only a limited number of wavelengths have been shown (e.g. four wavelengths only, around 400 GHz channel spacing). In these devices, the gain sections are in III-V material and the AWG, mirrors and couplers are in silicon. In case of ring-based lasers, the same principle is applied with the difference that the modal selectivity is obtained using ring resonators, instead of AWG. In some other techniques DVS-BCB adhesive bonding process is used (e.g. in the approach 2 wafer to wafer bonding) to provide a compact heterogeneously integrated III-V/silicon multi-wavelength lasers with intra-cavity ring-resonator based (de)multiplexer.

In the approaches described above, one SOA per channel is typically required for proper operation of the device. This requirement imposes an important drawback as it may hinder the reliability of the device and limit the number of channels. Furthermore, compatibility with CMOS manufacturing technology is reduced.

Manufacturing tunable lasers by hybridization through butt coupling between an SOA and a silicon photonic integrated circuit (PIC) has proven to be a successful approach with state-of-the-art performances of hybrid tunable lasers. This fabrication technique commonly involves the alignment of two devices, in this case at least one SOA with a silicon PIC. However, in case where a plurality of SOAs need to be aligned, such as the array of SOAs in the examples provided above, the alignment task may become quite complex.

Quantum dot or quantum dash materials are known to usable in order to make an active or passive mode locked laser (MLL). In these materials, stable combs can typically be generated where the mode spacing depends on the Fabry-Perot (FP) cavity length. However, in the known approaches only a few lines of the comb are usually used thus making the process relatively inefficient. Therefore, as a remedy, very high output power QD mode-locked lasers would be needed to guarantee a minimum level of output power per comb line. Another disadvantage of such MLL maybe the generation of mode partition noise.

The present disclosure proposes the use of a common gain medium for a plurality or all the lasers as described herein. Such common gain medium is inhomogeneously broadened. An inhomogeneously broadened gain medium, as known in the related, is capable of producing several ensemble gains at different energy levels for a series of different wavelengths. This is due to the existence of differences in one or more properties within the structure of the gain medium where such differences can produce an inhomogeneous broadening with respect to the optical transitions within the gain medium. For example, in Quantum Dot (QD) materials, such properties may, among others, relate to their dimensions, shape, strain, chemical composition or a combination thereof.

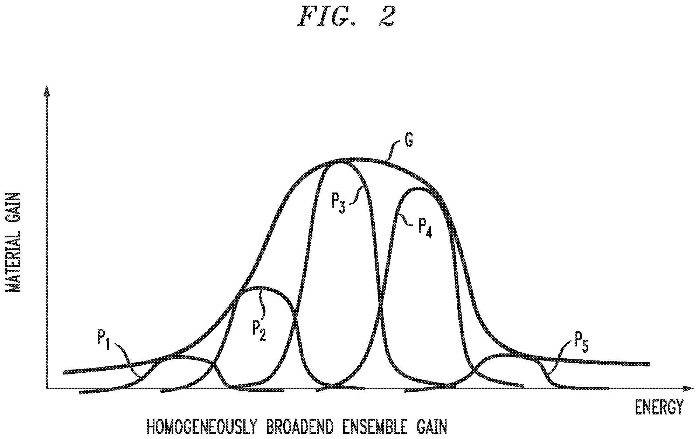

A typical gain spectra produced by an inhomogenously broadened material, for example a QD gain medium, is schematically represented in FIG. 2 where material gain (the Y axis) is represented as a function of energy levels (the X axis) for a plurality of wavelengths. As mentioned above, such ensemble gain is due to certain differences in one or more properties within the structure of the gain medium. Due to the non-homogenous fabrication of the gain material, different amplification are provided at spatially different locations of the gain material. Therefore, various homogeneous ensemble gains are produced each of which corresponding to a respective amplifications at such spatially different locations of the gain material. This results in several ensemble gain peaks P₁-Pₙ (five shown in FIG. 2) appearing at different zones of the spectra. Thus the inhomogeneously broadened gain medium has a gain function which is inhomogeneously broadened as represented by curve G in FIG.2 The present disclosure takes advantage of this phenomenon in conjunction with the use of various intra-cavity filters to provide the possibility of generating one laser line per ensemble gain, thus a multi-frequency spectrum. By using a silicon PIC based external-cavity, various filters can be implemented to allow only a single mode to lase in each gain ensemble. Each laser line can be tuned as desired.

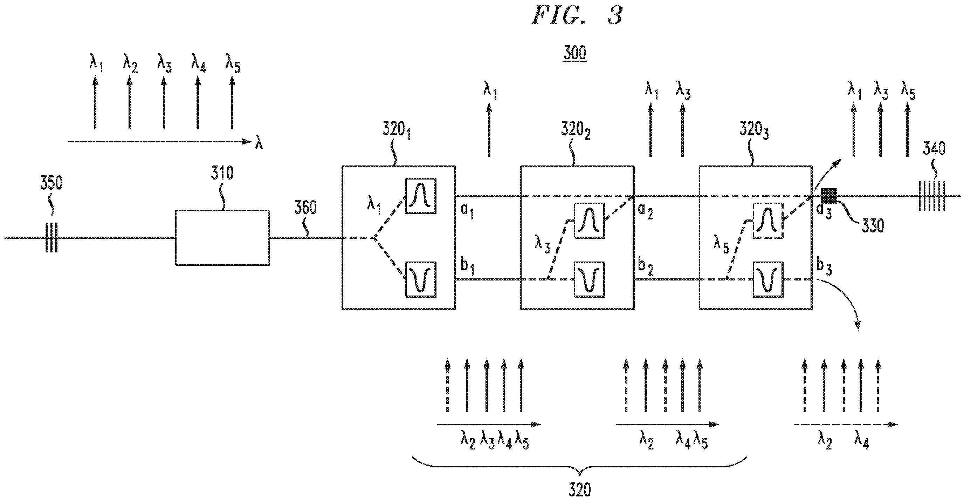

FIG. 3 is a schematic representation of an example of a multi-wavelength tunable apparatus (e.g. laser) 300 according to some embodiments. The apparatus 300 comprises an optical amplifier 310, a plurality of filters 320 comprising n filters 320₁ to 320ₙ (only three shown in the example of FIG. 3), an optical phase shifter 330, a high reflectivity mirror 340 and a partial reflectivity mirror 350, all optically coupled to one another through an optical path 360.

The optical amplifier 310 comprises an inhomogeneously broadened gain medium, as described above, which may be made of any known medium such as for example quantum dot or quantum dash material in a semiconductor optical amplifier, i.e. QD-SOA or an Erbium Doped fiber. The intra-cavity filters 320 may be made of any known filter structure such as for example ring resonators, coupled resonator optical waveguides (CROW), arrayed waveguide gratings, distributed Bragg filters, or Mach-Zhender interferometers (cascaded MZI). The optical phase shifter 330 may be for example thermal, carrier injection, or reversed biased pn-junction based. The high reflectivity mirror 340 may be for example a Sagnac loop mirror or a high reflectivity Bragg grating, a ring-based mirror or a metal coated high-reflectivity semiconductor facet; and the partial reflectivity mirror may be for example a partial reflectivity Bragg grating, a Sagnac loop mirror or a cleaved semiconductor facet. The optical path 360 may be provided using any suitable medium such as for example a waveguide.

As can be appreciated from the above, the optical amplifier 310, the optical filters 320, the phase shifter 330, all located between the high reflectivity mirror 340 and the partial reflectivity mirror 350 and optically coupled to each other through the optical path 360 form a laser cavity.

With this arrangement, an optical signal injected into the optical amplifier 310 will propagate through the inhomogeneously broadened gain medium of the optical amplifier 310 which comprises a plurality of ensemble gains, e.g. as shown in FIG. 2 (the number of ensemble gains may depend on the structure of the inhomogeneously broadened ensemble gain which may be designed according to each specific need). Each one of the plurality of ensemble gains (e.g. P₁-Pₙ in FIG. 2) is associated with a respective wavelength λ1, λ2, ..., λn (five shown in the example of FIG. 3). Light produced by spontaneous emission of each one of the plurality of ensemble gains is then input into the optical filters 320. Each one of the optical filters 320₁ - 320₃ is configured to split the incoming optical signal into branches such that in one branch one wavelength is allowed to pass and in the other (split) branch that same wavelength is blocked and the remaining wavelengths are allowed to pass. The filter therefore behaves as a notch or a band-pass filter depending on the port (branch) through which the optical signal passes. For example, as shown in FIG. 3, optical filter 320₁ is configured to allow the passage of wavelength λ1 from port a1 and allow the passage of wavelengths λ2-λ5 from port b1. In the next stage, filter 320₂ is configured to by-pass wavelength λ1, split wavelengths λ2-λ5 to allow the passage of wavelength λ3 from port a2 (together with wavelength λ1) and allow the passage of wavelengths λ2, λ4 and λ5 from port b2

Similarly, filter 320₃ is configured to by-pass wavelengths λ1 and λ3, split wavelengths λ2, λ4 and λ5 to allow the passage of wavelength λ5 from port a3 (together with wavelengths λ1 and λ3) and allow the passage of wavelengths λ2 and λ4 from port b3, where the latter wavelengths are discarded.

After passing through the filters, the wavelengths propagate through the phase shifter 330. The phase shifter 330 is preferably employed to control the position of the Fabry-Perot mode of the cavity when the apparatus is lasing. Next, upon reaching the high reflectivity mirror 340, the wavelenghts are reflected back into the optical path 360 where they travel through the same elements although in the opposite direction. In this opposite direction the optical signals (corresponding to the various wavelength ranges) are amplified once more in the optical amplifier 310 and impinge on the partially reflective mirror 350 where they are partially reflected back into the optical path 360. By propagating back and forth through the optical path 360, the optical signals are progressively amplified and once the lasing threshold is reached, the apparatus 300 starts to lase.

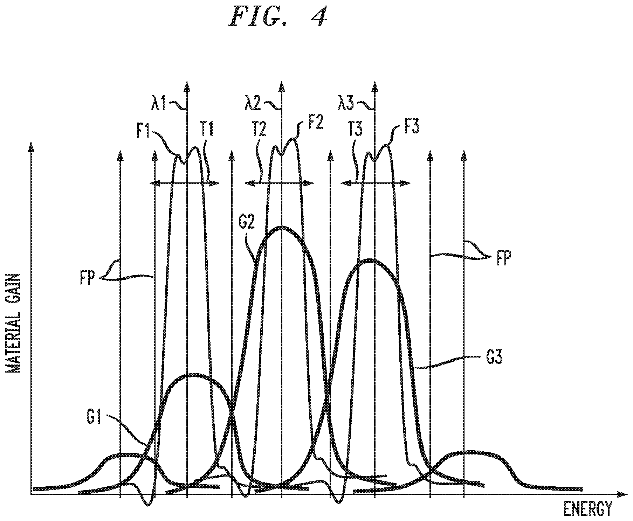

FIG. 4 shows an example of gain functions and the resulting wavelengths after lasing is triggered in apparatus of FIG. 3. In this example, for the purpose of illustration and not limitation, only three wavelengths λ1, λ2 and λ3, and thus, three ensemble gains G1, G2 and G3 are shown. The Fabry-Perot modes are represented by arrows FP. Three filters are employed each assigned to a respective one of the different tuning ranges T1, T2 and T3 corresponding to wavelengths λ1, λ2 and λ3. The transmission function of the filters are represented in FIG. 4 by F1, F2 and F3 corresponding to tuning ranges T1, T2 and T3 respectively. Therefore, with simultaneous reference to FIGS. 3 and 4 it may be concluded that filter 320₁ is associated to wavelength λ1 within the tuning range T1, filter 320₂ is associated to wavelength λ2 within the tuning range T2 and filter 320₃ is associated to wavelength λ3 within the tuning range T3. Within each ensemble gain spectra G1, G2 and G3, continuous tuning may be achieved by tuning of the filter 320₁, 320₂, 320₃ corresponding to that cavity and adjusting the phase of the optical signal. Therefore, each one of the wavelength λ1, λ2 and λ3 are tunable within their respective range as schematically shown by double-headed arrows T1, T2 and T3 in FIG. 4. Each Fabry-Perot mode selected (i.e. not blocked) by the respective filters becomes dominant and starts to lase. This is represented in FIG. 4 by λ1, λ2 and λ3.

In this manner, three independent continuously tunable laser lines corresponding to wavelengths λ1, λ2 and λ3 are emitted from the same inhomogeneously broadened gain semiconductor optical amplifier, thereby producing a multi-frequency spectrum. Each wavelength filter can be individually tunable to allow for continuous wavelength tuning over its respective individual ensemble gain spectra.

In order to avoid mode competition, it is preferable to avoid two neighboring filters from accessing the same gain region. This results in improvements in both the RIN and optical output power of each individual lasing line.

The solution proposed herein eliminates the need for using as many gain mediums (for lasers) as there are wavelengths.

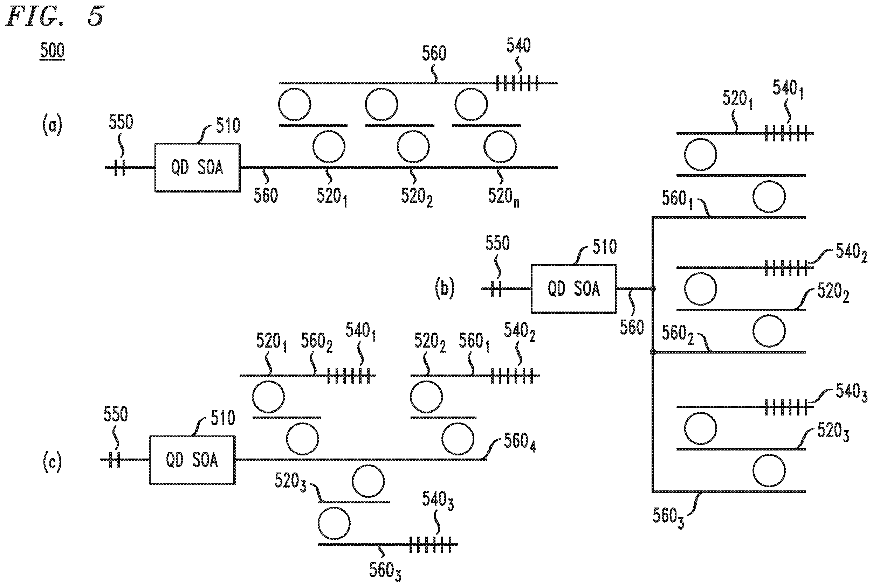

Various cavity configurations may be envisaged in the design of the apparatus as proposed herein. Some non-limiting examples are shown in FIG. 5. In the three embodiments (a), (b) and (c) of FIG. 5, like elements have been provided with like reference numerals.

In FIG. 5a, a first configuration is schematically shown where there is provided an apparatus 500 that comprises an optical amplifier 510, a plurality of filters 520 comprising n filters 520₁ to 520ₙ, a high reflectivity mirror 540 and a partial reflectivity mirror 550, all optically coupled to one another through an optical path 560. Optionally an optical phase shifter and a variable optical attenuator (not explicitly shown) may be employed.

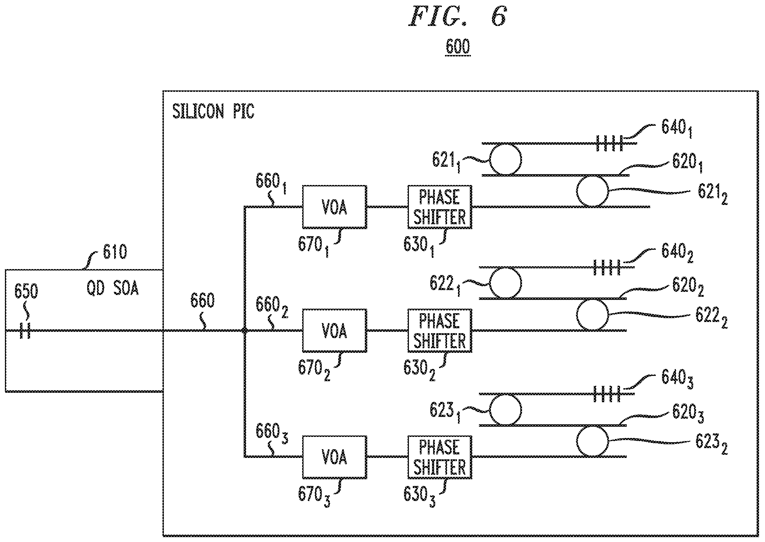

The optical amplifier 510 comprises an inhomogeneously broadened gain medium. The type and the principle of operation of the optical amplifier is the same or similar to the one already described with reference to FIG. 3. In this embodiment, the optical filters 520₁ to 520ₙ are ring resonator pairs. The ring resonators may be designed to produce the so-called Vernier effect as will be described in further detail with reference to FIG. 6.

In FIGS. 5b and 5c a second and a third configuration are schematically shown. The apparatus 500 comprises an optical amplifier 510, a plurality of filters 520 comprising n filters 520₁ to 520ₙ (only three are shown). Each filter 520 is located on a respective branch 560₁ to 560₃ of the optical path 560, the branches 560₁ to 560₃. A respective high reflectivity mirror 540₁ to 540₃ is provided at an end of each branch 560₁ to 560₃. The apparatus 500 further comprises a partial reflectivity mirror 550. The branches 560₁ to 560₃ merge with each other to form one optical path 560 which is coupled to the optical amplifier 510. In these embodiments the partial reflectivity mirror 550, the optical amplifier 510, the optical filter 520₁ and the high reflectivity mirror 540₁, optically coupled to each other through the optical path 560 and optical branch 560₁ form a first laser cavity. Likewise, the partial reflectivity mirror 550, the optical amplifier 510, the optical filters 520₂ and the high reflectivity mirror 540₂, optically coupled to each other through the optical path 560 and optical branch 560₂ form a second laser cavity; and the partial reflectivity mirror 550, the optical amplifier 510, the optical filters 520₃ and the high reflectivity mirror 540₃, optically coupled to each other through the optical path 560 and optical branch 560₃ form a third laser cavity.

In each embodiment also, the optical amplifier 510 comprises an inhomogeneously broadened gain medium. The type and the principle of operation of the optical amplifier is the same or similar to the one already described with reference to FIG. 3. In this embodiment, the optical filters 520₁ to 520ₙ are ring resonator pairs. The ring resonators may be designed to produce the so-called Vernier effect as will be described in further detail with reference to FIG. 6.

FIG. 6 is a schematic representation of an example of another embodiment of an apparatus as proposed herein.

Referring to FIG. 6, a parallel configuration is schematically shown where there is provided an apparatus 600 that comprises an optical amplifier 610, a plurality of filters 620 comprising n filters 620₁ to 620ₙ (only three are shown). Each filter 620 is located on a respective branch 660₁ to 660₃ of the optical path 660, the branches 660₁ to 660₃ being in parallel configuration. A respective high reflectivity mirror 640₁ to 640₃ is provided at an end of each branch 660₁ to 660₃.

Each branch (or optical path) 660₁ to 660₃ is further provided with a respective variable optical attenuator (VOA) 670₁ to 670₃. The VOAs may be switched ON (so as to block or substantially attenuate the passage of an optical signal therethrough) or switched OFF (so as to allow, with substantially no or negligible attenuation, the passage of an optical signal therethrough). Furthermore, a respective phase shifter 630₁ to 630₃ may be provided in each one of the branches 660₁ to 660₃.

Here also, the optical amplifier 610 comprises an inhomogeneously broadened gain medium, as described above, which may be made of any known medium such as those mentioned with reference to FIG. 3.

The apparatus 600 further comprises a partial reflectivity mirror 650 coupled to the amplifier 610. The branches 660₁ to 660₃ merge with each other to form one optical path 660 which is coupled to the optical amplifier 610. In this embodiment the partial reflectivity mirror 650, the optical amplifier 610, the optical filter 620₁ and the high reflectivity mirror 640₁, optically coupled to each other through the optical path 660 and optical branch 660₁ form a first laser cavity. Likewise, the partial reflectivity mirror 650, the optical amplifier 610, the optical filter 620₂ and the high reflectivity mirror 640₂, optically coupled to each other through the optical path 660 and optical branch 660₂ form a second laser cavity; and the partial reflectivity mirror 650, the optical amplifier 610, the optical filter 620₃ and the high reflectivity mirror 640₃, optically coupled to each other through the optical path 660 and optical branch 660₃ form a third laser cavity.

In the embodiment of FIG. 6, the optical filters are made of ring resonators. In particular, optical filter 620₁ comprises of a pair of ring resonators 621₁, 621₂; optical filter 620₂ comprises of a pair of ring resonators 622₁, 622₂ and optical filter 620₃ comprises of a pair of ring resonators 623₁, 623₂.

Each ring resonator pair comprises two ring resonators having slightly different free spectral ranges. For example the free spectral range (FSR) of one ring resonator in one of the above described ring resonator pairs may be 400 GHZ and the FSR of the other one of the same pair may be 440 GHZ. The difference between the respective FSRs of the ring resonators of the pair causes the so-called Vernier effect. The Vernier effect is a well-known phenomenon. Briefly, the Vernier effect is produced due to the difference in the FSRs of the ring resonators of a ring resonator pair which in turn causes the transmittance spectra of the two ring resonators in the pair overlap with each other, therefore enabling a wider combined free spectral range with an improved tunability range as compared to the tunability ranges available in individual ring resonators.

The operation of the apparatus 600, with reference to the first laser cavity is now described. It is assumed that an optical signal is injected into the optical path 660 in a first direction, e.g. from the partial reflectivity mirror 650 to the high reflectivity mirror 640₁. It is further assumed that the first VOA 670₁ is turned OFF (i.e. no or negligible attenuation is present).

The optical signal would propagate through the optical amplifier 610 where it is amplified. Furthermore, as the optical amplifier 610 comprises an inhomogeneously broadened gain medium, the amplification process produces a plurality of wavelengths where each is amplified by a respective ensemble gain as described with reference to FIG. 2.

The plurality of the wavelengths then propagate through the optical path 660 where they are split between the branches 660₁, 660₂ and 660₃, for example using an optical splitter/combiner (not explicitly shown). It is to be noted that in this direction of propagation, the plurality of spontaneous emissions from the ensemble gains are not split into individual wavelengths corresponding to respective ensemble gains each propagating through a different branch, rather the plurality of the spontaneous emissions from the ensemble gains is split into portions, where each portion comprises the same number of spontaneous emissions from the ensemble gains however with less power than the power of the spontaneous emissions from the ensemble gains before splitting.

Within the first branch 660₁ the portion of the split spontaneous emissions from the ensemble gains is input into the VOA 670₁ where it is allowed to pass without substantial attenuation (as the VOA is in OFF state). Next, the split portion of the spontaneous emissions from the ensemble gains in the first branch 660₁ is input in the phase shifter 630₁. The split portion of the spontaneous emissions from the ensemble gains output from the phase shifter 630₁ is then input into the first ring resonator pair 621₁, 621₂. As mentioned above the first ring resonator pair 621₁, 621₂ is configured to produce a Vernier effect based on the difference between the FSRs of the ring resonators. The first ring resonator pair 621₁, 621₂ filters the spontaneous emissions from the ensemble gains allowing one selected wavelength to pass and blocking the rest. The Vernier effect gives rise to a wider combined spectrum for the selected wavelength passing through the first ring resonator pair 621₁, 621₂ thus improving the tunability range of the wavelength. The selected wavelenght then propagates toward the high reflectivity mirror 640₁ where it is reflected back into the optical path 660₁ and propagates in a second direction, opposite to the first direction.

In the second direction, the selected wavelength propagates through the phase shifter 630₁, the VOA 670₁ and is input into the optical amplifier 610 through optical path 660. The wavelength is again amplified in the optical amplifier 610 and upon impinging on the partial reflectivity mirror 650 is partially reflected back into the optical amplifier, where it undergoes a further amplification and continues its propagation in the first direction as described above. As a result of such amplifications, the light intensity increases in every propagation cycle and when such intensity increases above a specific threshold, lasing occurs.

Similar processes may occur in the second and the third cavities. Assuming that various main gain peaks are available, corresponding to respective different ensemble gains, each laser cavity may be assigned to a different wavelength range. Therefore, the first laser cavity may be configured to allow the passage of a first wavelength range (blocking the others). Thus by tuning of the Vernier-based ring resonator pair 621₁, 621₂ for the first cavity, continuous tuning may be achieved. This effect allows the laser to operate in single-mode and wavelength tunability, which may for example enable a wavelength tunability of over 35 nm.

Although the VOAs 670₁ 670₂ and 670₃ are not needed in order to enable the apparatus 600 to generate a multiplicity of wavelengths, their presence in the apparatus can provide a broader range of operation. For example, using the VOAs makes it possible for the apparatus to operate enable or disable one or more branches of the apparatus 600. Indeed, in case it is desired to have a branch to operate as a laser cavity, the VOA corresponding to that branch is turned OFF (thus no or negligible attenuation is provided by the VOA). Conversely, if it is desired to disable a branch from operating as a laser cavity, the respective VOA on that branch can be turned ON to thereby substantially attenuate, or even block, the optical signal passing therethrough.

Preferably, any two cavities do not access the same gain region in order to avoid mode competition.

The VOAs may be of any known type. High-speed p-i-n junction VOAs may be used to enable switching between cavities based on carrier injection. The ring resonators may preferably be of racetrack type being designed to have an expected free spectral range (FSR) of 400 and 440 GHz in the front and in the back respectively.

The ring resonators may each be operated by thermo-optic effect to obtain tuning of the wavelength of the optical signal. For example, electrically excited metal heaters may be used on the ring resonators to allow thermal tuning of the ring resonator peak wavelengths. As this process maybe slow, i.e. tens of microseconds, the pre-tuning technique as described below may preferably be used to improve speed.

The optical amplifier may be made on a III-V chip and the VOAs, ring resonator pairs, mirrors and phase shifters may be made on a silicon chip. The two chips may be fabricated separately and subsequently hybridized. This process is feasible using the current commercial foundry and the compatibility with CMOS technology can be maintained.

In all the embodiments described above, the partial reflectivity mirror (350, 450, 550 and 650) may be integrated in the optical amplifier (310, 410, 510 and 610) such as a reflective optical amplifier, or it may be a discrete element optically coupled to the optical amplifier.

The present disclosure, proposes the use of an intra-cavity filter inserted in the cavity structure of a laser source to thereby generate only a few modes. In this manner, each selected comb line which passes through the filter benefits from the full local gain within the cavity which provides comparatively higher output power per comb line at the same injected electrical current. The proposed architecture provides a compact and low cost device which is capable of providing high efficiency, low noise and low power consumption.

Such novel multi-wavelength hybrid laser is based on only one optical amplifier hybridized with one photonic integrated circuit. The use of only one optical amplifier reduces the cost of manufacturing (as mentioned previously, gain material is more expensive than silicon). Each wavelength can be separately and continuously tuned.

Furthermore, in the present solution only one alignment would be needed which is advantageous over devices in which multiple optical amplifiers are used thus requiring multiple alignments or if an array of SOAs is used, a still more complex alignment would be needed.

The laser source as described herein may be assembled together with a modulator to form an optical transmitter usable in multi-wavelength applications, such as for example WDM transmission systems.

While this disclosure includes references to illustrative embodiments, this specification is not intended to be construed in a limiting sense. Various modifications of the described embodiments, as well as other embodiments within the scope of the disclosure, which are apparent to persons skilled in the art to which the disclosure pertains are deemed to lie within the principle and scope of the disclosure, e.g., as expressed in the following claims.

Unless explicitly stated otherwise, each numerical value and range should be interpreted as being approximate as if the word "about" or "approximately" preceded the value or range.

It will be further understood that various changes in the details, materials, and arrangements of the parts which have been described and illustrated in order to explain the nature of this disclosure may be made by those skilled in the art without departing from the scope of the disclosure, e.g., as expressed in the following claims.

Reference herein to "one embodiment" or "an embodiment" means that a particular feature, structure, or characteristic described in connection with the embodiment can be included in at least one embodiment of the disclosure. The appearances of the phrase "in one embodiment" in various places in the specification are not necessarily all referring to the same embodiment, nor are separate or alternative embodiments necessarily mutually exclusive of other embodiments. The same applies to the term "implementation."

The described embodiments are to be considered in all respects as only illustrative and not restrictive. In particular, the scope of the disclosure is indicated by the appended claims rather than by the description and figures herein. All changes that fall within the meaning and range of equivalency of the claims are to be embraced within their scope.

It should be appreciated by those of ordinary skill in the art that any block diagrams herein represent conceptual views of illustrative circuitry embodying the disclosed principles.

## Claims

1. An apparatus comprising:
- an optical amplifier (310) having an inhomogeneously broadened gain material configured to generate a plurality of ensemble gains; and
- a silicon photonic integrated circuit including a first optical filter (320₁) and a second optical filter (320₂);
wherein the inhomogeneously broadened gain material is capable of generating a plurality of ensemble gains, each one of which being associated with a respective wavelength;
wherein a first laser cavity includes the optical amplifier (310) and the first optical filter (320₁) optically coupled to each other and at least two mirrors (340, 350), and the first optical filter (320₁) is tunable to a respective first ensemble gain generated by the optical amplifier (310);wherein a second laser cavity includes the optical amplifier (310) and the second optical filter (320₂) optically coupled to each other and at least two mirrors (340, 350), and the second optical filter (320₂) is tunable to a respective second ensemble gain generated by the optical amplifier (310); and
wherein the second ensemble gain is different from the first ensemble gain.

2. The apparatus of claim 1, wherein the optical amplifier (310) is provided on a first substrate and the silicon photonic integrated circuit is provided on a second substrate, the first substrate and the second substrate together forming a hybrid structure.

3. The apparatus of claim 1, wherein the optical amplifier (310) is provided using erbium doped fiber and the silicon photonic integrated circuit is provided on a substrate wherein the erbium doped fiber and the substrate comprising the silicon photonic integrated circuit form together a hybrid structure.

4. The apparatus of any one of the preceding claims, wherein the first optical filter (320₁) and the second optical filter (3202) support different optical frequency modes and the optical amplifier (310) is configured to generate multiple ensemble gains corresponding to said different optical frequency modes.

5. The apparatus of any one of the preceding claims, wherein the first laser cavity comprises a first mirror with a first reflectivity and a second mirror with a second reflectivity, such that the first reflectivity is lower than the second reflectivity and the second laser cavity comprises the first mirror and the second mirror.

6. The apparatus of any one of the claims 1 to 4 wherein the first laser cavity comprises a first mirror with a first reflectivity and a second mirror with a second reflectivity, such that the first reflectivity is lower than the second reflectivity and the second laser cavity comprises the first mirror and a third mirror with a third reflectivity, such that the first reflectivity is lower than the third reflectivity.

7. The apparatus of any one of the preceding claims, wherein the first optical filter (320₁) comprises a first ring resonator pair which includes a first ring resonator (621₁) having a first free spectral range and a second ring resonator (621₂) having a second free spectral range, wherein the first free spectral range is different from the second free spectral range, such that the first ring resonator pair is configured to produce a Vernier effect on an optical signal.

8. The apparatus of claim 7, wherein the second optical filter (320₂) comprises a second ring resonator pair which includes a third ring resonator (622₁) having a third free spectral range and a fourth ring resonator (622₂) having a fourth free spectral range, wherein the third free spectral range is different from the fourth free spectral range, such that the second ring resonator pair is configured to produce a Vernier effect on an optical signal.

9. The apparatus of any one of the preceding claims, further comprising a phase shifter (330).

10. The apparatus of any one of the preceding claims, wherein the first laser cavity comprises a first variable optical attenuator (670₁) configured to attenuate the first ensemble gain in a switched ON condition and allow a passage of said first ensemble gain in a switched OFF condition.

11. The apparatus any one of the preceding claims, comprising a plurality of laser cavities, each comprising a respective variable optical attenuator (670₁, 670₂, 670₃) configured to attenuate an optical signal amplified by a respective ensemble gain in said cavity in a switched ON condition and allow a passage of said respective ensemble gain in a switched OFF condition.

12. The apparatus any one of the preceding claims, wherein the silicon photonic integrated circuit and the optical amplifier (310) are butt-coupled to each other.

13. The apparatus of claim 1, wherein the inhomogenously broadened material of the optical amplifier (310) is within a semiconductor optical amplifier comprising a quantum dot gain medium.

14. The apparatus of claim 1, wherein the inhomogenously broadened material of the optical amplifier (310) is within an Erbium Doped Fiber Amplifier.

15. The apparatus any one of the preceding claims, wherein the second mirror is a Sagnac loop mirror, ring-based mirror, Bragg grating mirror, coated facet mirror or a Bragg grating fiber.

16. The apparatus any one of the preceding claims, wherein the first mirror is a partially reflective Bragg grating fiber, a partially reflective Bragg grating, a partially reflective cleaved fiber or a partially reflective Sagnac loop mirror.

17. A laser source comprising:
- an optical amplifier (310) having an inhomogeneously broadened gain material configured to generate a plurality of ensemble gains; and
- a silicon photonic integrated circuit including a first optical filter (320₁) and a second optical filter (320₂);
wherein the inhomogeneously broadened gain material is capable of generating a plurality of ensemble gains, each one of which being associated with a respective wavelength;
wherein a first laser cavity includes the optical amplifier (310) and the first optical filter (320₁) optically coupled to each other and at least two mirrors (340, 350), and the first optical filter (320₁) is tunable to a respective first ensemble gain generated by the optical amplifier (310);wherein a second laser cavity includes the optical amplifier (310) and the second optical filter (320₂) optically coupled to each other and at least two mirrors (340, 350), and the second optical filter (320₂) is tunable to a respective second ensemble gain generated by the optical amplifier (310); and
wherein the second ensemble gain is different from the first ensemble gain.

18. A transmitter comprising:
- a modulator;
- an optical amplifier (310) having an inhomogeneously broadened gain material configured to generate a plurality of ensemble gains; and
- a silicon photonic integrated circuit including a first optical filter (320₁) and a second optical filter (320₂);
wherein the inhomogeneously broadened gain material is capable of generating a plurality of ensemble gains, each one of which being associated with a respective wavelength;
wherein a first laser cavity includes the optical amplifier (310) and the first optical filter (320₁) optically coupled to each other and at least two mirrors (340, 350), and the first optical filter (320₁) is tunable to a respective first ensemble gain generated by the optical amplifier (310);
wherein a second laser cavity includes the optical amplifier (310) and the second optical filter (320₂) optically coupled to each other and at least two mirrors (340, 350), and the second optical filter (320₂) is tunable to a respective second ensemble gain generated by the optical amplifier (310); and
wherein the second ensemble gain is different from the first ensemble gain.

## Patentansprüche

1. Vorrichtung, die Folgendes umfasst:
- einen optischen Verstärker (310) mit einem inhomogen verbreiterten Verstärkungsmaterial, der dazu ausgelegt ist, eine Vielzahl von Ensembleverstärkungen zu erzeugen; und
- eine siliziumphotonische integrierte Schaltung, die ein erstes optisches Filter (320₁) und ein zweites optisches Filter (320₂) beinhaltet;
wobei das inhomogen verbreiterte Verstärkungsmaterial in der Lage ist, eine Vielzahl von Ensembleverstärkungen zu erzeugen, von denen jede mit einer jeweiligen Wellenlänge verknüpft ist;
wobei eine erste Laserkavität den optischen Verstärker (310) und das erste optische Filter (320₁), die optisch aneinandergekoppelt sind, und mindestens zwei Spiegel (340, 350) beinhaltet und das erste optische Filter (320₁) auf eine jeweilige erste Ensembleverstärkung, die vom optischen Verstärker (310) erzeugt wird, abstimmbar ist; wobei eine zweite Laserkavität den optischen Verstärker (310) und das zweite optische Filter (320₂), die optisch aneinandergekoppelt sind, und mindestens zwei Spiegel (340, 350) beinhaltet und das zweite optische Filter (320₂) auf eine jeweilige zweite Ensembleverstärkung, die vom optischen Verstärker (310) erzeugt wird, abstimmbar ist; und
wobei sich die zweite Ensembleverstärkung von der ersten Ensembleverstärkung unterscheidet.

2. Vorrichtung nach Anspruch 1, wobei der optische Verstärker (310) auf einem ersten Substrat bereitgestellt ist und die siliziumphotonische integrierte Schaltung auf einem zweiten Substrat bereitgestellt ist, wobei das erste Substrat und das zweite Substrat zusammen eine hybride Struktur bilden.

3. Vorrichtung nach Anspruch 1, wobei der optische Verstärker (310) unter Verwendung einer erbiumdotierten Faser bereitgestellt ist und die siliziumphotonische integrierte Schaltung auf einem Substrat bereitgestellt ist, wobei die erbiumdotierte Faser und das Substrat, das die siliziumphotonische integrierte Schaltung umfasst, zusammen eine hybride Struktur bilden.

4. Vorrichtung nach einem der vorhergehenden Ansprüche, wobei das erste optische Filter (320₁) und das zweite optische Filter (320₂) verschiedene optische Frequenzmodi unterstützen und der optische Verstärker (310) dazu ausgelegt ist, mehrere Ensembleverstärkungen zu erzeugen, die den verschiedenen optischen Frequenzmodi entsprechen.

5. Vorrichtung nach einem der vorhergehenden Ansprüche, wobei die erste Laserkavität einen ersten Spiegel mit einem ersten Reflexionsvermögen und einen zweiten Spiegel mit einem zweiten Reflexionsvermögen umfasst, derart, dass das erste Reflexionsvermögen geringer ist als das zweite Reflexionsvermögen, und die zweite Laserkavität den ersten Spiegel und den zweiten Spiegel umfasst.

6. Vorrichtung nach einem der Ansprüche 1 bis 4, wobei die erste Laserkavität einen ersten Spiegel mit einem ersten Reflexionsvermögen und einen zweiten Spiegel mit einem zweiten Reflexionsvermögen umfasst, derart, dass das erste Reflexionsvermögen geringer ist als das zweite Reflexionsvermögen, und die zweite Laserkavität den ersten Spiegel und einen dritten Spiegel mit einem dritten Reflexionsvermögen umfasst, derart, dass das erste Reflexionsvermögen geringer ist als das dritte Reflexionsvermögen.

7. Vorrichtung nach einem der vorhergehenden Ansprüche, wobei das erste optische Filter (320₁) ein erstes Ringresonatorpaar, das einen ersten Ringresonator (621₁) mit einem ersten freien Spektralbereich und einen zweiten Ringresonator (621₂) mit einem zweiten freien Spektralbereich beinhaltet, umfasst, wobei sich der erste freie Spektralbereich vom zweiten freien Spektralbereich unterscheidet, derart, dass das erste Ringresonatorpaar dazu ausgelegt ist, einen Verniereffekt am optischen Signal zu produzieren.

8. Vorrichtung nach Anspruch 7, wobei das zweite optische Filter (320₂) ein zweites Ringresonatorpaar, das einen dritten Ringresonator (622₁) mit einem dritten freien Spektralbereich und einen vierten Ringresonator (622₂) mit einem vierten freien Spektralbereich beinhaltet, umfasst, wobei sich der dritte freie Spektralbereich vom vierten freien Spektralbereich unterscheidet, derart, dass das zweite Ringresonatorpaar dazu ausgelegt ist, einen Verniereffekt am optischen Signal zu produzieren.

9. Vorrichtung nach einem der vorhergehenden Ansprüche, die ferner einen Phasenverschieber (330) umfasst.

10. Vorrichtung nach einem der vorhergehenden Ansprüche, wobei die erste Laserkavität einen ersten variablen optischen Dämpfer (670₁) umfasst, der dazu ausgelegt ist, in einem eingeschalteten Zustand die erste Ensembleverstärkung zu dämpfen und in einem ausgeschalteten Zustand ein Durchleiten der ersten Ensembleverstärkung zu erlauben.

11. Vorrichtung nach einem der vorhergehenden Ansprüche, die eine Vielzahl von Laserkavitäten umfasst, von denen jede einen jeweiligen variablen optischen Dämpfer (670₁, 670₂, 670₃) umfasst, die dazu ausgelegt sind, in einem eingeschalteten Zustand ein optisches Signal, das von einer jeweiligen Ensembleverstärkung in der Kavität verstärkt wird, zu dämpfen und in einem ausgeschalteten Zustand ein Durchleiten der jeweiligen Ensembleverstärkung zu erlauben.

12. Vorrichtung nach einem der vorhergehenden Ansprüche, wobei die siliziumphotonische integrierte Schaltung und der optische Verstärker (310) eine Stoßkopplung miteinander aufweisen.

13. Vorrichtung nach Anspruch 1, wobei sich das inhomogen verbreiterte Material des optischen Verstärkers (310) in einem optischen Halbleiterverstärker befindet, der ein Quantenpunktverstärkungsmedium umfasst.

14. Vorrichtung nach Anspruch 1, wobei sich das inhomogen verbreiterte Material des optischen Verstärkers (310) in einem erbiumdotierten Faserverstärker befindet.

15. Vorrichtung nach einem der vorhergehenden Ansprüche, wobei der zweite Spiegel ein Sagnac-Schleifenspiegel, ein ringbasierter Spiegel, ein Bragg-Gitterspiegel, ein beschichteter Facettenspiegel oder eine Bragg-Gitterfaser ist.

16. Vorrichtung nach einem der vorhergehenden Ansprüche, wobei der erste Spiegel eine teilweise reflektierende Bragg-Gitterfaser, ein teilweise reflektierendes Bragg-Gitter, eine teilweise reflektierende gespaltene Faser oder ein teilweise reflektierender Sagnac-Schleifenspiegel ist.

17. Laserquelle, die Folgendes umfasst:
- einen optischen Verstärker (310) mit einem inhomogen verbreiterten Verstärkungsmaterial, der dazu ausgelegt ist, eine Vielzahl von Ensembleverstärkungen zu erzeugen; und
- siliziumphotonische integrierte Schaltung, die ein erstes optisches Filter (320₁) und ein zweites optisches Filter (320₂) beinhaltet;
wobei das inhomogen verbreiterte Verstärkungsmaterial in der Lage ist, eine Vielzahl von Ensembleverstärkungen zu erzeugen, von denen jede mit einer jeweiligen Wellenlänge verknüpft ist;
wobei eine erste Laserkavität den optischen Verstärker (310) und das erste optische Filter (320₁), die optisch aneinandergekoppelt sind, und mindestens zwei Spiegel (340, 350) beinhaltet und das erste optische Filter (320₁) auf eine jeweilige erste Ensembleverstärkung, die vom optischen Verstärker (310) erzeugt wird, abstimmbar ist; wobei eine zweite Laserkavität den optischen Verstärker (310) und das zweite optische Filter (320₂), die optisch aneinandergekoppelt sind, und mindestens zwei Spiegel (340, 350) beinhaltet und das zweite optische Filter (320₂) auf eine jeweilige zweite Ensembleverstärkung, die vom optischen Verstärker (310) erzeugt wird, abstimmbar ist; und
wobei sich die zweite Ensembleverstärkung von der ersten Ensembleverstärkung unterscheidet.

18. Sender, der Folgendes umfasst:
- einen Modulator;
- einen optischen Verstärker (310) mit einem inhomogen verbreiterten Verstärkungsmaterial, der dazu ausgelegt ist, eine Vielzahl von Ensembleverstärkungen zu erzeugen; und
- siliziumphotonische integrierte Schaltung, die ein erstes optisches Filter (320₁) und ein zweites optisches Filter (320₂) beinhaltet;
wobei das inhomogen verbreiterte Verstärkungsmaterial in der Lage ist, eine Vielzahl von Ensembleverstärkungen zu erzeugen, von denen jede mit einer jeweiligen Wellenlänge verknüpft ist;
wobei eine erste Laserkavität den optischen Verstärker (310) und das erste optische Filter (320₁), die optisch aneinandergekoppelt sind, und mindestens zwei Spiegel (340, 350) beinhaltet und das erste optische Filter (320₁) auf eine jeweilige erste Ensembleverstärkung, die vom optischen Verstärker (310) erzeugt wird, abstimmbar ist;
wobei eine zweite Laserkavität den optischen Verstärker (310) und das zweite optische Filter (320₂), die optisch aneinandergekoppelt sind, und mindestens zwei Spiegel (340, 350) beinhaltet und das zweite optische Filter (320₂) auf eine jeweilige zweite Ensembleverstärkung, die vom optischen Verstärker (310) erzeugt wird, abstimmbar ist; und
wobei sich die zweite Ensembleverstärkung von der ersten Ensembleverstärkung unterscheidet.

## Revendications

1. Appareil comprenant :
- un amplificateur optique (310) possédant un matériau à gain élargi de manière non homogène configuré pour générer une pluralité de gains d'ensemble ; et
- un circuit intégré photonique en silicium comprenant un premier filtre optique (320₁) et un second filtre optique (320₂) ;
dans lequel le matériau à gain élargi de manière non homogène est capable de générer une pluralité de gains d'ensemble, qui sont chacun associés à une longueur d'onde respective ;
dans lequel une première cavité de laser comprend l'amplificateur optique (310) et le premier filtre optique (320₁) couplés optiquement l'un à l'autre et au moins deux miroirs (340, 350), et le premier filtre optique (320₁) est réglable sur un premier gain d'ensemble respectif généré par l'amplificateur optique (310) ; dans lequel une seconde cavité de laser comprend l'amplificateur optique (310) et le second filtre optique (320₂) couplés optiquement l'un à l'autre et au moins deux miroirs (340, 350), et le second filtre optique (320₂) est réglable sur un second gain d'ensemble respectif généré par l'amplificateur optique (310) ; et
dans lequel le second gain d'ensemble est différent du premier gain d'ensemble.

2. Appareil selon la revendication 1, dans lequel l'amplificateur optique (310) est prévu sur un premier substrat et le circuit intégré photonique en silicium est prévu sur un second substrat, dans lequel le premier substrat et le second substrat forment ensemble une structure hybride.

3. Appareil selon la revendication 1, dans lequel l'amplificateur optique (310) est prévu à l'aide d'une fibre dopée à l'erbium et le circuit intégré photonique en silicium est prévu sur un substrat, dans lequel la fibre dopée à l'erbium et le substrat qui comprend le circuit intégré photonique en silicium forment ensemble une structure hybride.

4. Appareil selon l'une quelconque des revendications précédentes, dans lequel le premier filtre optique (320₁) et le second filtre optique (320₂) prennent en charge différents modes de fréquence optique et l'amplificateur optique (310) est configuré pour générer plusieurs gains d'ensemble qui correspondent auxdits différents modes de fréquence optique.

5. Appareil selon l'une quelconque des revendications précédentes, dans lequel la première cavité de laser comprend un premier miroir avec une première réflectivité et un deuxième miroir avec une deuxième réflectivité, de sorte que la première réflectivité soit inférieure à la deuxième réflectivité, et la seconde cavité de laser comprend le premier miroir et le deuxième miroir.

6. Appareil selon l'une quelconque des revendications 1 à 4, dans lequel la première cavité de laser comprend un premier miroir avec une première réflectivité et un deuxième miroir avec une deuxième réflectivité, de sorte que la première réflectivité soit inférieure à la deuxième réflectivité, et la seconde cavité de laser comprend le premier miroir et un troisième miroir avec une troisième réflectivité, de sorte que la première réflectivité soit inférieure à la troisième réflectivité.

7. Appareil selon l'une quelconque des revendications précédentes, dans lequel le premier filtre optique (320₁) comprend une première paire de résonateurs en anneau qui comprend un premier résonateur en anneau (621₁) qui possède une première plage spectrale libre et un deuxième résonateur en anneau (621₂) qui possède une deuxième plage spectrale libre, dans lequel la première plage spectrale libre est différente de la deuxième plage spectrale libre, de sorte que la première paire de résonateurs en anneau soit configurée pour produire un effet de Vernier sur un signal optique.

8. Appareil selon la revendication 7, dans lequel le second filtre optique (320₂) comprend une seconde paire de résonateurs en anneau qui comprend un troisième résonateur en anneau (622₁) qui possède une troisième plage spectrale libre et un quatrième résonateur en anneau (622₂) qui possède une quatrième plage spectrale libre, dans lequel la troisième plage spectrale libre est différente de la quatrième plage spectrale libre, de sorte que la seconde paire de résonateurs en anneau soit configurée pour produire un effet de Vernier sur un signal optique.

9. Appareil selon l'une quelconque des revendications précédentes, comprenant en outre un déphaseur (330).

10. Appareil selon l'une quelconque des revendications précédentes, dans lequel la première cavité de laser comprend un premier atténuateur optique variable (670₁) configuré pour atténuer le premier gain d'ensemble dans un état ON et pour permettre le passage dudit premier ensemble de gain dans un état OFF.

11. Appareil selon l'une quelconque des revendications précédentes, comprenant une pluralité de cavités de laser, qui comprennent chacune un atténuateur optique variable respectif (670₁, 670₂, 670₃) configuré pour atténuer un signal optique amplifié par un gain d'ensemble respectif dans ladite cavité dans un état ON et pour permettre le passage dudit gain d'ensemble respectif dans un état OFF.

12. Appareil selon l'une quelconque des revendications précédentes, dans lequel le circuit intégré photonique en silicium et l'amplificateur optique (310) sont couplés bout à bout l'un à l'autre.

13. Appareil selon la revendication 1, dans lequel le matériau élargi de manière non homogène de l'amplificateur optique (310) se trouve dans un amplificateur optique à semiconducteur qui comprend un milieu de gain à points quantiques.

14. Appareil selon la revendication 1, dans lequel le matériau élargi de manière non homogène de l'amplificateur optique (310) se trouve dans un amplificateur à fibre dopée à l'erbium.

15. Appareil selon l'une quelconque des revendications précédentes, dans lequel le deuxième miroir est un miroir à boucle de Sagnac, un miroir annulaire, un miroir à réseau de Bragg, un miroir à facettes traitées, ou une fibre à réseau de Bragg.

16. Appareil selon l'une quelconque des revendications précédentes, dans lequel le premier miroir est une fibre à réseau de Bragg partiellement réfléchissante, un réseau de Bragg partiellement réfléchissant, une fibre clivée partiellement réfléchissante ou un miroir à boucle de Sagnac partiellement réfléchissant.

17. Source laser comprenant :
- un amplificateur optique (310) possédant un matériau à gain élargi de manière non homogène configuré pour générer une pluralité de gains d'ensemble ; et
- un circuit intégré photonique en silicium comprenant un premier filtre optique (320₁) et un second filtre optique (320₂) ;
dans lequel le matériau à gain élargi de manière non homogène est capable de générer une pluralité de gains d'ensemble, qui sont chacun associés à une longueur d'onde respective ;
dans lequel une première cavité de laser comprend l'amplificateur optique (310) et le premier filtre optique (320₁) couplés optiquement l'un à l'autre et au moins deux miroirs (340, 350), et le premier filtre optique (320₁) est réglable sur un premier gain d'ensemble respectif généré par l'amplificateur optique (310) ; dans lequel une seconde cavité de laser comprend l'amplificateur optique (310) et le second filtre optique (320₂) couplés optiquement l'un à l'autre et au moins deux miroirs (340, 350), et le second filtre optique (320₂) est réglable sur un second gain d'ensemble respectif généré par l'amplificateur optique (310) ; et
dans lequel le second gain d'ensemble est différent du premier gain d'ensemble.

18. Transmetteur comprenant :
- un modulateur ;
- un amplificateur optique (310) possédant un matériau à gain élargi de manière non homogène configuré pour générer une pluralité de gains d'ensemble ; et
- un circuit intégré photonique en silicium comprenant un premier filtre optique (320₁) et un second filtre optique (320₂) ;
dans lequel le matériau à gain élargi de manière non homogène est capable de générer une pluralité de gains d'ensemble, qui sont chacun associés à une longueur d'onde respective ;
dans lequel une première cavité de laser comprend l'amplificateur optique (310) et le premier filtre optique (320₁) couplés optiquement l'un à l'autre et au moins deux miroirs (340, 350), et le premier filtre optique (320₁) est réglable sur un premier gain d'ensemble respectif généré par l'amplificateur optique (310) ;
dans lequel une seconde cavité de laser comprend l'amplificateur optique (310) et le second filtre optique (320₂) couplés optiquement l'un à l'autre et au moins deux miroirs (340, 350), et le second filtre optique (320₂) est réglable sur un second gain d'ensemble respectif généré par l'amplificateur optique (310) ; et
dans lequel le second gain d'ensemble est différent du premier gain d'ensemble.
